# EUROPÄISCHE PATENTANMELDUNG

(11) **EP 1 170 398 A1**
(43) Veröffentlichungstag der Anmeldung: **09.01.2002**
(21) Anmeldenummer: 01115334.3
(22) Anmeldetag: 26.06.2001
(51) Int. Cl.: C23C 16/30, C23C 14/06

(54) **Schneideinsatz zum Zerspanen und Verfahren zu seiner Herstellung**

(30) Priorität: 03.07.2000 DE 10031327
(71) Anmelder: Widia GmbH, 45145 Essen (DE)
(72) Erfinder: König, Udo, Dr., 45149 Essen (DE); Tabersky, Ralf, Dipl.-Phys., 46240 Bottrop (DE)
(74) Vertreter: Vomberg, Friedhelm, Dipl.-Phys.

(57) **Zusammenfassung**

Die Erfindung betrifft einen Schneideinsatz aus einem Substratkörper mit einer ein- oder mehrlagigen Beschichtung, wovon die einzige oder mindestens eine Schicht, vorzugsweise die äußerste, aus einem Festschmierstoff besteht. Erfindungsgemäß wird als Festschmierstoff MeSₓ mit 0,8 ≤ x ≤ 0,2 und Me = Ti, Zr oder Hf, vorzugsweise TiSₓ vorgeschlagen. Zur Herstellung dieser Festschmierstoffschicht wird ein CVD-Verfahren verwendet, bei dem der in die Gasphase eingeleitete Schwefelspender, nämlich H₂S, SF₆, SF₄, SO₂ und/oder COS sowie Metallhalogenide und Wasserstoff in die Gasphase eingeleitet werden. Alternativ kann der Festschmierstoff mittels eines PVD-Verfahrens abgeschieden werden.

## Beschreibung

Die Erfindung betrifft einen Schneideinsatz zum Zerspanen, bestehend aus einem Hartmetall-, Cermet-, Keramik- oder Stahlgrundkörper und mindestens einer hierauf abgeschiedenen Schicht, wovon die einzige oder mindestens eine, mindestens 0,5 µm dicke Schicht, vorzugsweise die äußerste Schicht, aus einem Festschmierstoff besteht.

Die Erfindung betrifft ferner ein Verfahren zur Herstellung einer Festschmierstoffschicht auf einem Grundkörper oder auf einem beschichteten Grundkörper.

Die Beschichtung von Grundkörpern aus Hartmetall, einem Cermet, einer Keramik oder Stahl mit Hartstoffen oder Hartstoffmischungen oder auch Keramikwerkstoffen ist nach dem Stand der Technik seit langem bekannt. Hierzu werden insbesondere Carbide, Nitride, Carbonitride, Oxicarbonitride, Oxide und/oder Boride mindestens eines der Elemente der IVB-, VB- und/oder VIB-Gruppe des Periodensystemes, wie beispielsweise TiC, TiN, Ti(C,N), oder auch keramische Werkstoffe wie Al₂O₃ oder ZrO₂ verwendet. Bei hohen Schnittgeschwindigkeiten und/oder großen Spanungsquerschnitten entstehen mitunter insbesondere bei schwer zerspanbaren Werkstoffen hohe Temperaturen an der Schneide des Zerspanungswerkzeuges, die wiederum einen erhöhten Verschleiß, zum Teil auch Kantenausbrüche zur Folge haben. Um die beim Zerspanen an der Werkzeugschneide auftretenden Temperaturen zu minimieren, werden daher üblicherweise sogenannte Kühlschmierstoffe verwendet, die jedoch umwelt- und gesundheitsgefährdende Substanzen enthalten und unter Aufwendung hoher Kosten entsorgt werden müssen.

In der EP 0 534 905 A2 wird daher vorgeschlagen, Werkzeuge für die zerspanende Bearbeitung von Werkstoffen mit einer Oberflächenschicht zu versehen, die aus mindestens einer Verbindung aus mindestens einem Hauptgruppenelement der VI. Gruppen des periodischen Systemes einerseits und mindestens einem Nebengruppenelement der V. und VI. Gruppe des periodischen Systemes andererseits bestehen. Als bevorzugt werden Selenide, Sulfide und Telluride der Elemente Molybdän, Niob, Tantal und Wolfram vorgeschlagen, wovon sich in der jüngsten Zeit insbesondere das Molybdänsulfid durchgesetzt hat.

In der DD 202 898 wird vorgeschlagen, auf Schnitt-, Stanz-, Zieh- und Zerspanungswerkzeuge, Lagern oder ähnlichem Molybdändisulfid durch Sputtern aufzutragen, wobei sich die Schichtdicke im nm-Bereich bewegen soll.

Zudem wird in der DE 198 25 572 A1 ein Werkzeug der eingangs genannten Art vorgeschlagen, bei dem die einzige oder die äußere Schicht im wesentlichen aus Molybdänsulfid besteht und einen Chlorgehalt von 0,5 bis 6 Atom% aufweist. Durch diese Maßnahme soll die Haftung und die Oxidationsbeständigkeit der Molybdänschicht verbessert werden.

In der DE 195 11 829 A1 wird ein Schneidwerkzeug mit einem Schaft und einem Schneidenteil beschrieben, das mit einer Gleitschicht geringerer Härte als eine Grundschicht des Schneidteiles beschichtet ist. Der Grundkörper des Schneidteiles soll aus HSS, Hartmetall, Cermet oder Keramik und die Grundschicht aus TiN, TiAlN, TiCN, Diamant oder ähnlichem bestehen. Als Gleitschichtmaterial werden Sulfide, Selenide oder Telluride der Elemente Molybdän, Niob, Tantal oder Wolfram genannt.

Es ist Aufgabe der vorliegenden Erfindung, einen Schneideinsatz der eingangs genannten Art zu schaffen, bei dem die Festschmierstoffschicht dicht, hart und temperaturstabil ist.

Diese Aufgabe wird durch den Schneideinsatz nach Anspruch 1 gelöst.

Erfindungsgemäß besteht der Festschmierstoff aus einem Titan-, Zirkonium- oder Hafnium-Sulfid der Form MeSₓ, wobei Me eines der vorgenannten Metalle, insbesondere Titan ist und 0,8 ≤ x ≤ 2,2 erfüllt wird. Gegen die Verwendung von Titansulfid als Trockenschmierstoffschicht bestand aus folgenden Gründen ein fachliches Vorurteil. Abgeschiedenes Molybdänsulfid besteht aus einem Schichtgitter aus hexagonalen S-Mo-S-Lagen. Die Dreifachlagen sind miteinander nur durch schwache Bindungskräfte gebunden, so daß bei Reibbeanspruchungen die S-Mo-S-Lagen aufeinander gleiten und dadurch sehr geringe Reibungskoeffizienten entstehen. Beim Titansulfid sind solche Voraussetzungen hingegen nicht gegeben, da aufgrund der Kristallstrukturen von TiS und TiS₂ wesentlich stärkere atomare Bindungen vorhanden sind. Nach den bisherigen Erkenntnissen ist daher nicht vorstellbar, daß der besonders beim Molybdänsulfid wirksame Effekt von intrakristallinen Gleitungen auch beim Titansulfid vorhanden ist. Überraschenderweise zeigt die vorliegende Erfindung, daß auch bei der Verwendung von Titansulfidschichten ein beachtlicher Trockenschmiereffekt auftritt, was die nachfolgend behandelten Ausführungsbeispiele auch belegen. Gegenüber dem bisher als Festschmierstoff bevorzugt verwendeten Molybdändisulfid sind Titansulfidschichten zudem nicht nur dichter und härter, sondern auch gegen Oxidationen bei hohen Temperaturen resistenter. Die vorzugsweise verwendete Titansulfidschicht kann als einzige Beschichtung auf einen Substratkörper unmittelbar oder als äußerste Schicht auf einen beschichteten Substratkörper aufgetragen werden. Die bevorzugte Festschmierstoff-Schichtdicke liegt zwischen 1 µm und 5 µm.

Nach einer Weiterbildung der Erfindung besteht die Festschmierstoffschicht aus reinem TiS oder aus einem Gemisch der Phasen TiS und TiS₂.

Nach einer weiteren Ausgestaltung der Erfindung ist zwischen dem Grundkörper und der Festschmierstoffschicht mindestens eine aus Carbiden, Nitriden, Carbonitriden, Oxinitriden, Oxicarbonitriden, Oxiden und/oder Boriden der Elemente der IVB-, VB- und/oder VIB-Gruppe des Periodensystemes und/oder einer Keramik, insbesondere Al₂O₃ oder mehrphasigen Gemischen hieraus bestehende Schicht angeordnet. Bevorzugt werden von den genannten Hartstoffschichten Titannitrid, Titancarbid und/oder Titancarbonitrid, wobei die erste, auf dem Grundkörper abgeschiedene Schicht eine TiN-Schicht ist.

Nach einer weiteren Ausgestaltung der Erfindung ist es auch möglich, daß auf der Festschmierstoffschicht eine äußere dünne TiN-Schicht abgeschieden ist, die vorzugsweise eine Dicke zwischen 0,5 µm bis 1 µm besitzt. Die Gesamtdicke aller auf dem Grundkörper abgeschiedenen Schichten, die unterhalb der Festschmierstoffschicht liegen, beträgt 0,5 µm bis 20 µm.

Zur Abscheidung der Festschmierstoffschichten nach der vorliegenden Erfindung kann auf die nach dem Stand der Technik bekannten Verfahren, nämlich PVD oder CVD zurückgegriffen werden. Hierbei wird insbesondere das plasmaunterstützte CVD-Verfahren (PCVD) bevorzugt. Bei Verwendung von CVD-Verfahren wird in das Beschichtungsgefäß als Schwefel-Donator H₂S, SF₆, SF₄, SO₂ und/oder COS ebenso wie ein Titan-, Zirkonium- oder Hafniumhalogenid und Wasserstoff sowie ggf. Argon eingeleitet. Das bevorzugt verwendete PCVD-Verfahren wird unter einem Druck von 50 Pa bis 1000 Pa und Temperaturen von 500°C bis maximal 750°C durchgeführt.

Bei einem CVD- bzw. PCVD-Verfahren, mittels dessen eine oder mehrere Hartstoffschichten wie beispielsweise die Schichtfolge TiN-Ti(C,N)-TiSₓ aufgetragen wird, wird die Schichtfolge durch Änderung der Gaszusammensetzung "in einer Hitze" erzeugt.

Weitere Vorteile der Erfindung ergeben sich aus nachfolgenden Ausführungsbeispielen.

Ausgangspunkt waren handelsübliche Wendeschneidplatten der Ausführungsform CNMG120408 aus einer Hartmetallegierung, die sich aus 6 Massen% Co, 8 Massen% (Ti,Ta,Nb)C und 86 Massen% WC zusammensetzt. Unter den verschiedenartigen nach dem Stand der Technik bekannten CVD- und PVD-Beschichtungsverfahren zur Herstellung von verschleißbeständigen Schichten ist das durch ein Glimmentladungsplasma aktivierte CVD-Verfahren ausgewählt worden, das im einzelnen in der DE 38 41 731 C1 beschrieben ist. Mit diesen Verfahren wurde zunächst bei einer Temperatur von 620°C, einem Druck von 300 Pa und unter Verwendung einer Gasmischung aus 77 vol-% H₂, 10 vol-% N₂, 12 vol-% Ar und 1 vol-% TiCl₄ auf den Hartmetallsubstraten eine 4 um dicke Schicht aus Titannitrid abgeschieden. Während der Beschichtungszeit von 150 Minuten wurde durch eine gepulste Gleichspannung (Spannung 470 V, Pulsdauer 50 µs, Pulspause 80 µs) ein Glimmentladungsplasma aufrechterhalten. Bei sonst gleichbleibenden Einstellungen wurde sodann eine Gasmischung aus 96 vol-% H₂, 2 vol-% H₂S und 2 vol-% TiCl₄ eingeleitet. Im Anschluß an diesen 90 Minuten dauernden Schritt wurde die Energiezufuhr abgeschaltet. Die Proben wurden abschließend in einer Atmosphäre aus Wasserstoff und Argon abgekühlt.

Anschließende Untersuchungen ergaben, daß sich auf den Substraten mit der Titannitridschicht eine 2 bis 3 µm dicke, bronzefarbene Schicht gebildet hatte. Durch mikroskopische Untersuchungen konnte festgestellt werden, daß diese Schicht aus einem dichten, kristallinen Gefüge bestand, die gut auf der Zwischenschicht aus Titannitrid haftete. Die Mikrohärte der äußeren Titansulfid-Schicht betrug 1030 HV05. Röntgenspektroskopische Untersuchungen ergaben ferner, daß das Atomverhältnis des Titan zum Schwefel nahe bei 1 lag (gemessenes Verhältnis Ti: S = 1,02). Durch Röntgenbeugungsuntersuchungen wurde eine hexagonale Struktur von TiS mit a = 0,33 nm und c = 0,638 nm gefunden.

Weitere Beschichtungen mit anderen Versuchsparametern ergaben, daß das Atomverhältnis von S : Ti von etwa 0,8 bis 2,2 variiert werden kann. Die Zusammensetzung TiSₓ mit 0,8 ≤ x ≤ 2,2 richtet sich in erster Linie nach dem Mischungsverhältnis des titanhaltigen Gases (TiCl₄) und des Schwefelhaltigen Gases (H₂S) sowie nach der Temperatur während der Beschichtung. Je nach Versuchseinstellungen konnten auch TiSₓ-Schichten erhalten werden, bei denen die abgeschiedene Schicht aus einem Phasengemisch aus TiS und TiS₂ bestand.

Wie bereits eingangs erwähnt, besteht bei der Bearbeitung von Werkstücken durch Drehen, Fräsen und Bohren ein großes Interesse, diese Bearbeitungsvorgänge ohne (umweltfeindliche) flüssige Kühlschmierstoffe durchzuführen. Mit den bisher zur Trockenbearbeitung vorgeschlagenen verschiedenen Schichtstoffen und Schichtsystemen, insbesondere aus Molybdändisulfid, konnten bereits beachtliche Fortschritte erzielt werden. Kristalline Molybdändisulfidschichten können durch CVD- oder Plasma-CVD-Verfahren hergestellt werden, allerdings bereitet die Handhabung des Prekursors für Molybdän, nämlich Molybdänchlorid beträchtliche Schwierigkeiten, da hierfür besondere Generatoren und Transportsysteme vorzusehen sind. Bei der Abscheidung von Titansulfid durch ein CVD- oder Plasma-CVD-Verfahren sind demgegenüber die technischen Voraussetzungen günstiger. Die Versorgung mit Titantetrachlorid gehört zur Grundausstattung der üblichen CVD- oder Plasma-CVD-Apparate für Hartstoffbeschichtungen, die häufig aus Carbiden, Nitriden und/oder Carbonitriden des Titan bestehen. Zur Herstellung von TiSₓ-Schichten ist somit bei den bestehenden Apparaturen lediglich noch eine Leitung für die Zufuhr von gasförmigem H₂S vorzusehen.

Die erfindungsgemäß beschichteten Schneideinsätze (Wendeschneidplatten) haben auch hervorragende Gebrauchseigenschaften, was anhand von durchgeführten Versuchen bei der Drehbearbeitung einer Welle aus rostfreiem Stahl festgestellt wurde. Die Bearbeitungsparameter und Versuchsergebnisse der nach dem vorstehenden Ausführungsbeispiel hergestellten Schneidkörper sind im folgenden aufgeführt:
Werkstückstoff: Stahl X5CrNi1810 (Schlüssel-nr. 1.4301)
Schneidkörper: CNMG120408
Schnittgeschwindigkeit: 160 m/min
Schnittiefe: 2,5 mm
Vorschub: 0.315 mm/U
Kein flüssiger Kühlschmierstoff

| Ausführung | | Schichten | Standzeit |
|---|---|---|---|
| (1) | ohne erfindungsgemäße äußere Schicht | TiN (6 µm) | 14 min |
| | | | |
| (2) | äußere Schicht | TiN (4 µm) | |
| | TiSₓ, x = 1.02 | TiS (2 µm) | 21 min |
| | | | |
| (3) | ohne erfindungsgemäße äußere Schicht | TiN-TiCN-TiN (7 µm) | 18 min |
| | | | |
| (4) | äußere Schicht | TiN-TiCN-TiN (5 µm) | |
| | TiS/TiS₂ Phasengemenge | TiS+TiS₂ (2,4 µm) | 27 min |

Bei der Ausführung (2) gemäß obiger Tabelle wurden TiN und TiSₓ in einem Beschichtungszyklus durch ein Plasma-CVD-Verfahren aufgebracht. Die mehrlagige Beschichtung TiN-TiCN-TiN gemäß Ausführungsbeispiel (3) nach obiger Tabelle wurde in einem gesonderten Beschichtungslauf durch thermisches CVD bei etwa 1000°C hergestellt. Aus dem Vorrat der beschichteten Platten wurde das Substrat für die Ausführung (4) in obiger Tabelle ausgewählt. Die Mischphasenschicht TiS + TiS₂ wurde danach durch ein Plasma-CVD-Verfahren bei einer Temperatur von 680°C unter Verwendung einer Gasmischung mit einem Verhältnis der Volumenanteile von H₂S/TiCl₄ von 2/1 abgeschieden.

Alle durchgeführten Schneidhaltigkeitsversuche wurden bis zum Bruch der Schneidecken oder einem unzulässig hohen Verschleiß der Wendeschneidplatten ausgedehnt. Ein Vergleich der in der vorstehenden Tabelle angegebenen Standzeiten zeigt, daß die Standzeit der erfindungsgemäßen Ausführungen gegenüber solchen Ausführungen ohne TiSₓ-Schichten erheblich erhöht werden kann, nämlich in den angegebenen Ausführungsbeispielen um jeweils 50 %.

## Patentansprüche

1. Schneideinsatz zum Zerspanen, bestehend aus einem Hartmetall-, Cermet-, Keramik- oder Stahlgrundkörper und mindestens einer hierauf abgeschiedenen Schicht, wovon die einzige oder mindestens eine, mindestens 0,5 µm dicke Schicht, vorzugsweise die äußerste, aus einem Festschmierstoff besteht,
**dadurch gekennzeichnet,**
**daß** der Festschmierstoff aus MeSₓ mit 0,8 ≤ x ≤ 2,2 und Me = Ti, Zr oder Hf, vorzugsweise TiSₓ, besteht.

2. Schneideinsatz nach Anspruch 1, **dadurch gekennzeichnet, daß** die Festschmierstoff-Schichtdicke zwischen 1 µm und 5 µm liegt.

3. Schneideinsatz nach Anspruch 1 oder 2, **dadurch gekennzeichnet, daß** die Festschmierstoffschicht aus reinem TiS oder aus einem Gemisch der Phasen TiS und TiS₂ besteht.

4. Schneideinsatz nach einem der Ansprüche 1 bis 3, **dadurch gekennzeichnet, daß** zwischen dem Grundkörper und der Festschmierstoffschicht mindestens eine aus Carbiden, Nitriden, Carbonitriden, Oxinitriden, Oxiden und/oder Boriden der Element der IVB-, VB- und/oder VIB-Gruppe des Periodensystemes oder mehrphasigen Gemischen hieraus und/oder Keramik, vorzugsweise Al₂O₃ bestehende Schicht angeordnet ist.

5. Schneideinsatz nach einem der Ansprüche 1 bis 4, **dadurch gekennzeichnet, daß** auf der Festschmierstoffschicht eine TiN-Schicht als äußerste Schicht, vorzugsweise einer Dicke zwischen 0,5 µm bis 1 µm, abgeschieden worden ist.

6. Schneideinsatz nach einem der Ansprüche 1 bis 5, **dadurch gekennzeichnet, daß** die Gesamtdicke aller auf dem Grundkörper abgeschiedenen Schichten, die unterhalb der Festschmierstoffschicht liegen, 0,5 µm bis 20 µm beträgt.

7. Verfahren zur Herstellung einer Festschmierstoffschicht nach einer der Ansprüche 1 bis 6 auf einem Grundkörper oder auf einem beschichteten Grundkörper, **dadurch gekennzeichnet, daß** der mittels eines CVD- oder eines plasmaunterstützten CVD-Verfahrens abgeschiedene Festschmierstoff durch in die Gasphase eingeleitete Schwefelspender, nämlich H₂S, SF₆, SF₄, SO₂ und/oder COS und Ti-, Zr- oder Hf-Halogenide und Wasserstoff sowie ggf. Argon oder mittels eines PVD-Verfahrens abgeschieden wird.

8. Verfahren nach Anspruch 7, **dadurch gekennzeichnet, daß** der Festschmierstoff mittels eines PCVD-Verfahrens unter einem Druck von 50 Pa bis 1000 Pa und einer Temperatur von maximal 750°C abgeschieden wird.

9. Verfahren nach Anspruch 7 oder 8, **dadurch gekennzeichnet, daß** alle Hartstoffschichten und die Festschmierstoffschicht durch Änderung der Gaszusammensetzung nacheinander mittels eines PCVD-Verfahrens abgeschieden werden.
